(19) Europäisches Patentamt
European Patent Office
Office européen des brevets

(11) **EP 3 540 448 A1**

(12) **EUROPEAN PATENT APPLICATION**

(43) Date of publication:
**18.09.2019 Bulletin 2019/38**

(21) Application number: **18382166.9**

(22) Date of filing: **14.03.2018**

(51) Int Cl.:
***G01R 19/02*** *(2006.01)*          *G01R 19/25* *(2006.01)*
*H02M 1/42* *(2007.01)*          *G05F 1/70* *(2006.01)*
*H02J 3/18* *(2006.01)*

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Fico Triad, S.A.**
**08028 Barcelona (ES)**

(72) Inventor: **DURÁN RIVAS, Raúl**
**08232 VILADECAVALLS (BARCELONA) (ES)**

(74) Representative: **Herrero & Asociados, S.L.**
**Cedaceros, 1**
**28014 Madrid (ES)**

(54) **ELECTRONIC DEVICE WITH PFC CIRCUIT AND METHOD FOR MEASURING ALTERNATING CURRENT INPUT TO THE ELECTRONIC DEVICE**

(57) An electronic device (100) and method for measuring input current (lac) comprising a controller (102) on which PFC is running; a power switch (103) through which a current is flowing, the current sampled in synchronization with a pulse-width modulator (105) connected between the power switch (103) and the controller (102); and a current sensing element (104) connected to the power switch (103) and from which a sensed current ($I_{sense}$) is measured and used by the controller (102) to perform the PFC. The sensed current ($I_{sense}$) sampled by the pulse-width modulator (105) at any time interval in which the power switch (103) is in conduction is also used by the controller (102) to estimate the root mean square value of the input alternating current (lac).

**EP 3 540 448 A1**

## Description

## Field of the invention

The present invention has its application within the electric power sector providing power supply units and/or power converter equipment. More particularly, the present invention can be applied to power supplies and power converters that are sourced by Alternating-Current (AC) mains and comprise a PFC (Power Factor Correction) pre-regulator circuit.

The present invention relates to an electronic device and method for measuring current input through the PFC circuit of a power delivery system.

## Background of the invention

Traditional approaches for measuring the current sourced by the AC mains/grid require a dedicated circuitry. Normally the existing solutions for measuring the AC mains are based on one of the following current sensing devices: shunt resistor, current sense transformer, hall-effect sensor or a rogowsky sensor.

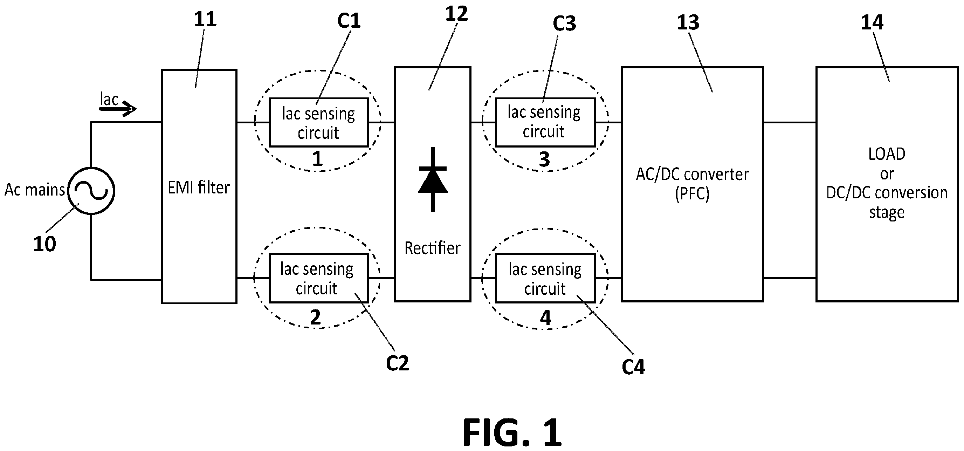

Figure 1 shows an example of the four possible locations (1, 2, 3, 4) for the AC input current (lac) sensing circuit (C1, C2, C3, C4) in a typical power supplier or power converter sourced by AC mains (10) and which includes an Alternating Current/Direct Current converter or AC/DC converter (13) implementing Power Factor Correction, PFC, before delivering power to the final load or DC/DC conversion stage (14). After filtering the AC input current (lac) from the AC mains (10) by an Electro-Magnetic Interference or EMI filter (11), the AC input current sensing circuit (C1, C2) can be located between the EMI filter (11) and the rectifier (12). Other conventional implementation option is that the sensing circuit (C3, C4) is located after the rectifier (12) and before reaching the PFC at the AC/DC converter (13).

In any case, a dedicated current sensing device and a dedicated signal conditioning circuit for the current sensing device are required. The signal conditioning circuit is normally more complex, due to the fact that the measured signal is normally a differential signal (floating versus the zero-potential/reference point of the signal conditioning circuit). If the current measurement needs to be digitized, e.g., to be measured by a microcontroller, a dedicated Analog to Digital Converter (ADC) is required. Therefore, higher parts count is required and a higher area/space on Printed Circuit Board (PCB) is consumed.

In some approaches, in order to estimate/calculate the root mean squared, rms, value of the AC-mains current (lac), the PFC circuit component values (prone to fluctuations) are normally used. However, these PFC component values are subject to changes due to tolerances and variations, such as the PFC coil inductance.

Therefore, it is highly desirable to provide an electronic device capable of sensing the AC-mains input current with a non-dedicated circuitry but with a shared circuit used for other purpose and without requiring the use of PFC component values in the calculation/estimation of the AC-mains current rms value.

## Summary of the invention

The present invention solves the aforementioned problems and overcomes previously explained state-of-art work limitations by providing an electronic device with an active PFC circuit and a continuous current output. The PFC circuit, in addition to correcting the power factor, also serves here to measure the current input to the PFC circuit itself, for applications such as diagnosis or control of the electronic device itself.

The proposed electronic device re-uses the sensing circuitry provided by the PFC pre-regulator to accomplish a double function: to perform the normal operation of the PFC itself and to sense the AC-mains current. The proposed electronic device can estimate/calculate the AC-mains input root mean squared (rms) value directly from a current (Ids) flowing through a power switch (i.e. MOSFET, bipolar transistor, insulated-gate bipolar transistor or IGBT) acquired by this sensing circuit in the PFC pre-regulator.

The present invention applies to electronic devices with PFC circuits that operate in continuous conduction mode (CCM), wherein the control algorithm of the PFC (either analog or digital) is runned by a controller (i.e. control IC, real time (RT) microcontroller unit (MCU), digital signal processing unit (DSP)).

An aspect of the present invention refers to an electronic device with power factor correction (PFC) circuitry which is used for measuring an alternating current input to the electronic device, comprising:

- a controller on which a PFC regulation algorithm is running;
- a power switch, where the current flowing through it is sampled and synchronized with a pulse-width modulator (PWM) connected between the power switch and the controller;
- a current sensing element connected to the power switch and from which a sensed current is measured and used by the controller to perform the PFC regulation;

the electronic device being characterized in that the controller uses the sensed current not only to perform the PFC regulation but also uses the sensed current sampled at any time interval in which the power switch is in conduction to estimate the root mean square value of the input alternating current.

Another aspect of the present invention refers to a method for measuring an alternating current input to the electronic device with PFC described before, which is implemented by the electronic device itself reusing the PFC circuit.

The present invention has a number of advantages with respect to prior art, which can be summarized as follows:

- The proposed device does need neither any dedicated circuitry to measure the AC input current nor any dedicated signal conditioning circuitry for said dedicated measurement circuitry, as the own circuit used for PFC operation is re-used.
- The present invention allows the digitization of the AC current measurement without an extra cost /effort, as the computational power offered by the controller used for the PFC operation is re-used for this purpose.
- None PFC circuit component theoric value (e.g the switching inductor coil) is needed for the calculation of the rms value of the AC-mains current. Therefore the AC-mains current rms value can be calculated with a better accuracy.
- The present invention has a lower parts count and lower production cost as requires less components. Also, the proposed device requires smaller PCB area, therefore, saving space and reducing the design complexity.
- The proposed device allows RT-MCU/DSP peripherals re-usability (ADC converter) and RT-MCU/ DSP programming code re-usability.
- Diagnose of mains current is possible (real time measurement and overcurrent / under-current protections implementation is possible) and eventually less complicated signal conditioning stage.

These and other advantages will be apparent in the light of the detailed description of the invention.

**Description of the drawings**

For the purpose of aiding the understanding of the characteristics of the invention, according to a preferred practical embodiment thereof and in order to complement this description, the following Figures are attached as an integral part thereof, having an illustrative and non-limiting character:

Figure 1 shows a power system comprising a PFC circuit and the possible locations for an AC mains input current sensing circuit in the system, as known in prior art.

Figure 2 shows a power system comprising AC mains input current sensing circuit within the PFC circuit, according to a preferred embodiment of the invention.

Figure 3 shows the electronic components of the power electronic device for sensing the AC mains input current and regulating PFC, according to a possible embodiment of the invention.

Figure 4 shows the waveforms of the AC mains input current and the current from the sensing element of the PFC, and the instants when the current of the PFC power switch, which is a MOSFET in the present embodiment, is sampled using PWM modulation.

**Preferred embodiment of the invention**

The matters defined in this detailed description are provided to assist in a comprehensive understanding of the invention. Accordingly, those of ordinary skill in the art will recognize that variation changes and modifications of the embodiments described herein can be made without departing from the scope and spirit of the invention. Also, description of well-known functions and elements are omitted for clarity and conciseness.

Of course, the embodiments of the invention can be implemented in a variety of architectural platforms, operating and server systems, devices, systems, or applications. Any particular architectural layout or implementation presented herein is provided for purposes of illustration and comprehension only and is not intended to limit aspects of the invention.

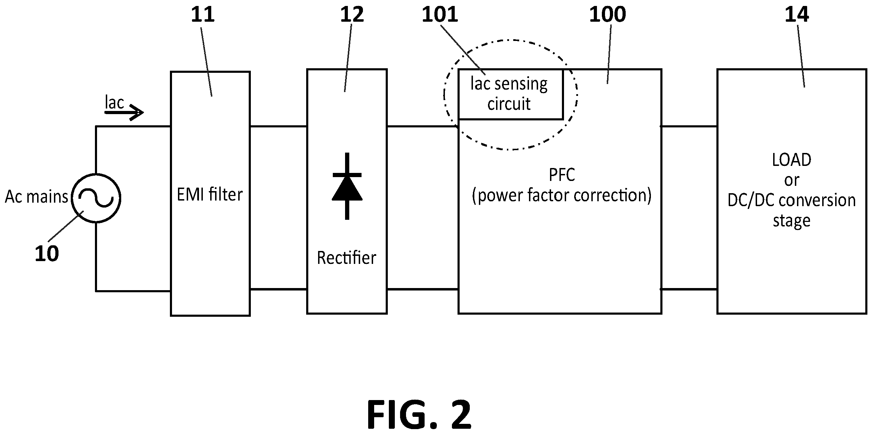

Figure 2 presents an electronic device **100** capable of sensing the alternating current **Iac** from AC mains **10** of a power delivery system by using a sensing circuit **101** provided by a regulator implementing the Power Factor Correction, PFC, within the electronic device **100.**

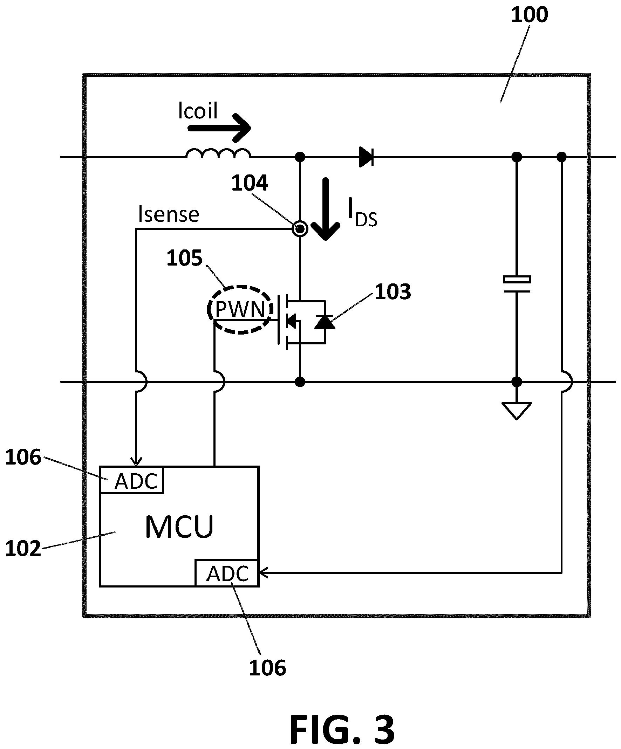

Figure 3 shows in further detail the electronic device (100), which comprises:

- a controller **102,** which can be a control integrated circuit (IC), a real time (RT) microcontroller unit (MCU) or a digital signal processing unit (DSP), on which a PFC control/regulation algorithm is running and the controller **102** comprising at least one Analog to Digital Converters **106** (ADC);
- a power switch **103,** e.g., a metal-oxide-semiconductorfield-effect transistor or MOSFET , generating a MOSFET drain to source current $I_{DS}$ which is sampled using a pulse-width modulator **105** (PWM) connected between the power switch **103** and the controller **102;**
- a current sensing element **104,** e.g., a coil, connected to the MOSFET power switch **103** and from which a sensed current $I_{sense}$ is measured by the controller **102,** the sensed current $I_{sense}$ being used by said controller **102** to perform the PFC control.

As shown in Figure 3:

- The alternating current **Iac** from AC mains **10** is equal to the PFC coil current $I_{coil}$ flowing through the coil, i.e., the current sensing element **104.**
- For the time interval where the PFC coil is charged, the PFC MOSFET drain to source current $I_{DS}$ is equal to PFC coil current $I_{coil}$.

Therefore, the input alternating current **Iac** from AC mains **10** is indirectly measured through the PFC MOSFET drain to source current $I_{DS}$, which in turn is already measured/needed by the PFC control algorithm running on the controller **102** to allow the PFC operation. The MOSFET drain to source current $I_{DS}$ is sampled right at any time interval, preferably at the middle of the time interval, where the MOSFET, i.e., the power switch **103** in this example, is in conduction and the coil is being charged. The sampled MOSFET drain to source current $I_{DS}$ current is already a kind of averaged version of the input alternating current **Iac.**

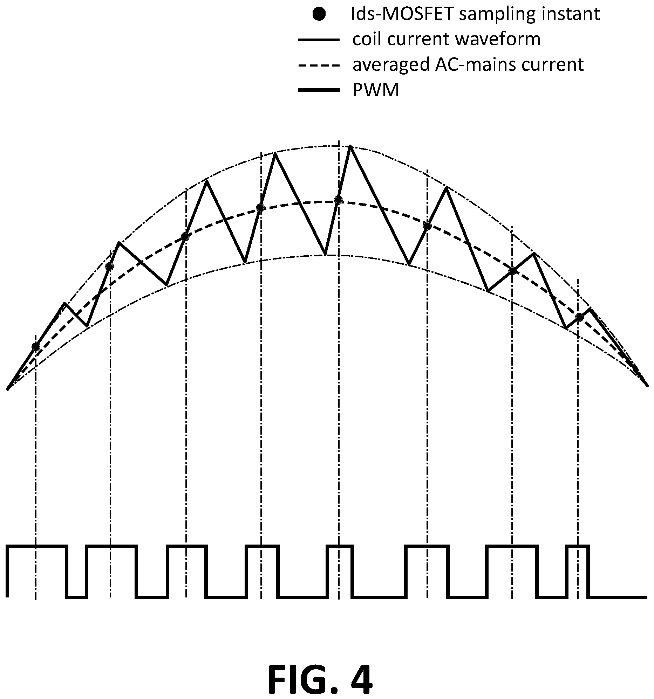

As shown in Figure 4, the sampling instants of the MOSFET drain to source current $I_{DS}$, coincide with the averaged waveform of the input alternating current **Iac** from AC mains **10**. Note that the sampling instant is at the middle of the PWM pulses duration.

The rms value, $I_{AC-rms}$, of the AC-mains current **Iac,** can be simply estimated/calculated by the controller **102** as follows:

$$I_{AC-rms} = \sqrt{\frac{\sum_{i=0}^{N} I_{DS}(i)^2}{N}}$$

where N = number of sampled points/instants.

This proposed electronic device **100** accepts several kinds of current sensing elements **104,** which can be freely selected according to the needs of the application: shunt resistor, current sense transformer, hall effect sensor, rogowsky coil, etc.

Note that in this text, the term "comprises" and its derivations (such as "comprising", etc.) should not be understood in an excluding sense, that is, these terms should not be interpreted as excluding the possibility that what is described and defined may include further elements, steps, etc.

**Claims**

1. An electronic device (100) with power factor correction, PFC, for measuring an input alternating current (Iac), comprising:

   - a controller (102) on which a PFC regulation algorithm is running;
   - a power switch (103) through which a current is flowing, the current being sampled in synchronization with a pulse-width modulator (105) connected between the power switch (103) and the controller (102);
   - a current sensing element (104) connected to the power switch (103) and from which a sensed current ($I_{sense}$) is measured and used by the controller (102) to perform the PFC regulation;

the electronic device (100) being **characterized in that** the controller (102) uses the sensed current ($I_{sense}$) sampled by the pulse-width modulator (105) at any time interval in which the power switch (103) is in conduction to estimate the root mean square value of the input alternating current (Iac).

2. The electronic device (100) according to claim 1, wherein the controller (102) is configured to estimate the root mean square value, $I_{AC-rms}$, of the input alternating current (Iac) by calculating:

$$I_{AC-rms} = \sqrt{\frac{\sum_{i=0}^{N} I_{DS}(i)^2}{N}}$$

where N is a number of instants at which the current ($I_{DS}$) of the power switch (103) is sampled.

3. The electronic device (100) according to any preceding claim, wherein the controller (102) is selected from a control integrated circuit, a real time microcontroller unit and a digital signal processing unit.

4. The electronic device (100) according to any preceding claim, wherein the power switch (103) is selected from a MOSFET, a bipolar transistor and an IGBT.

5. The electronic device (100) according to any preceding claim, wherein the current sensing element (104) is selected from a shunt resistor, a current sense transformer, a hall effect sensor and a rogowsky coil.

6. The electronic device (100) according to any preceding claim, wherein the controller (102) uses the sensed current ($I_{sense}$) sampled at the middle time interval in which the power switch (103) is in conduction to estimate the root mean square value of the input alternating current (Iac).

7. The electronic device (100) according to any preceding claim, wherein the alternating current (Iac) comes from AC mains (10) power supply.

8. A method for measuring an alternating current (Iac) input to an electronic device (100) with power factor correction, PFC, comprising:

   - running a PFC regulation algorithm by a controller (102) of the electronic device (100);
   - sampling a current flowing through a power switch (103) of the electronic device (100) in synchronization with a pulse-width modulator (105) connected between the power switch (103) and the controller (102) within the electronic device (100);
   - measuring a sensed current ($I_{sense}$) by a cur-

rent sensing element (104) connected to the power switch (103) and using the sensed current ($I_{sense}$) by the controller (102) to perform the PFC regulation;

the method being **characterized by** further comprising using the sensed current ($I_{sense}$) sampled by the pulse-width modulator (105) at any time interval in which the power switch (103) is in conduction to estimate by the controller (102) the root mean square value of the input alternating current (lac).

9. The method according to claim 8, wherein estimating the root mean square value, $I_{AC-rms}$, of the input alternating current (lac) by by the controller (102) comprises calculating:

$$I_{AC-rms} = \sqrt{\frac{\sum_{i=0}^{N} I_{DS}(i)^2}{N}}$$

where N is a number of instants at which the current ($I_{DS}$) of the power switch (103) is sampled.

10. The method according to any of claims 8-9, wherein estimating the root mean square value of the input alternating current (lac) by the controller (102) uses the sensed current ($I_{sense}$) sampled at the middle time interval in which the power switch (103) is in conduction.

**FIG. 1**

EP 3 540 448 A1

FIG. 2

**FIG. 3**

FIG. 4

Europäisches
Patentamt

European
Patent Office

Office européen
des brevets

**EUROPEAN SEARCH REPORT**

Application Number

EP 18 38 2166

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 204 013 207 U (ZHUHAI GREE ELEC APPLIANCES) 10 December 2014 (2014-12-10)<br>* figures 2-4 *<br>* paragraph [0022] - paragraph [0049] * | 1-10 | INV.<br>G01R19/02<br><br>ADD.<br>G01R19/25<br>H02M1/42<br>G05F1/70<br>H02J3/18 |
| X | JOEL TURCHI: "Power Factor Correction Stages Operating in Critical Conduction Mode",<br>ON SEMICONDUCTOR APPLICATION NOTE,,<br>vol. AND8123/D, no. Rev. 1,<br>1 September 2003 (2003-09-01), pages 1-18,<br>XP002599562,<br>* figures 1-4 *<br>* page 1 - page 6 * | 1-10 | |
| A | JONG-WON SHIN ET AL: "Digital Average Current Mode Control of Boost Converter Using Diode Current Sensing Technique",<br>???????????,<br>1 July 2009 (2009-07-01), pages 305-307,<br>XP055502368,<br>* the whole document * | 6,10 | |
| A | US 2015/146458 A1 (LIM SHU FAN [SG])<br>28 May 2015 (2015-05-28)<br>* the whole document * | 6,10 | TECHNICAL FIELDS SEARCHED (IPC)<br><br>G01R<br>H02M<br>G05F<br>H02J<br>H01M |
| A | US 2016/020692 A1 (CASTELLI CLAUDIA [IT])<br>21 January 2016 (2016-01-21)<br>* the whole document * | 1-10 | |
| A | US 2014/052394 A1 (SUN BOSHENG [US])<br>20 February 2014 (2014-02-20)<br>* the whole document * | 1-10 | |

The present search report has been drawn up for all claims

| Place of search | Date of completion of the search | Examiner |
|---|---|---|
| Munich | 28 August 2018 | Nguyen, Minh |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 38 2166

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2018

| Patent document cited in search report | | | Publication date | Patent family member(s) | | | Publication date |
|---|---|---|---|---|---|---|---|
| CN 204013207 | U | | 10-12-2014 | NONE | | | |
| US 2015146458 | A1 | | 28-05-2015 | DE | 102014117331 | A1 | 28-05-2015 |
| | | | | US | 2015146458 | A1 | 28-05-2015 |
| US 2016020692 | A1 | | 21-01-2016 | CN | 105281556 | A | 27-01-2016 |
| | | | | CN | 204947893 | U | 06-01-2016 |
| | | | | US | 2016020692 | A1 | 21-01-2016 |
| US 2014052394 | A1 | | 20-02-2014 | CN | 104583784 | A | 29-04-2015 |
| | | | | JP | 6204474 | B2 | 27-09-2017 |
| | | | | JP | 2015527044 | A | 10-09-2015 |
| | | | | US | 2014052394 | A1 | 20-02-2014 |
| | | | | WO | 2014031653 | A1 | 27-02-2014 |

EPO FORM P0459

For more details about this annex : see Official Journal of the European Patent Office, No. 12/82